# EUROPEAN PATENT APPLICATION

(11) **EP 1 148 555 A1**
(43) Date of publication of application: **24.10.2001**
(21) Application number: 00830308.3
(22) Date of filing: 21.04.2000
(51) Int. Cl.: H01L 29/78, H01L 29/36, H01L 29/08

(54) **RESURF LDMOS field-effect transistor**

(71) Applicant: STMicroelectronics S.r.l., 20041 Agrate Brianza (Milano) (IT)
(72) Inventor: Croce, Giuseppe, 20049 Concorezzo (IT); Moscatelli, Alessandro, 22070 Casnate con Bernate (IT); Merlini, Alessandra, 20054 Nova Milanese (IT); Galbiati, Paola, 20052 Monza (IT)
(74) Representative: Pellegri, Alberto

(57) **Abstract**

A RESURF LDMOS integrated structure realized in a first region (drain well) of a first type of conductivity defined in a semiconductor substrate of opposite type of conductivity and comprising a source region of said first type of conductivity formed in a body region of said opposite type of conductivity. Said body region is contained within a surface portion (body buffer region) of the first region that is more heavily doped than the rest of the region to avoid punch-through when the structure operates as a high side driver.

## Description

### FIELD OF THE INVENTION

The present invention relates to integrated circuits that exploit the so-called RESURF (acronym of REduced SURface Field) condition in which power devices capable of withstanding relatively high voltages, typically n-channel LDMOS and/or lateral p-channel MOS transistors, may respectively function with source or drain untied from ground potential.

### BACKGROUND OF THE INVENTION

The ability to withstand a relatively high voltage of field effect CMOS lateral transistors such as for example n-channel LDMOS and p-channel MOS transistors may be enhanced through the so-called RESURF technique.

The RESURF effect is exploited by realizing the integrated circuits in a relatively thin epitaxial layer and by accurately controlling the diffusion implants such to allow integration of lateral CMOS transistors capable to withstand relatively high voltages.

RESURF LDMOS structures are particularly interesting because they offer an optimal compromise between specific resistance and breakdown voltage, reducing power dissipation as well as the thickness of the silicon dice.

The main objective to pursue in designing an LDMOS RESURF structure is to ensure that the DRAIN_WELL region be completely depleted before critical electric fields in correspondence with the gate oxide develop.

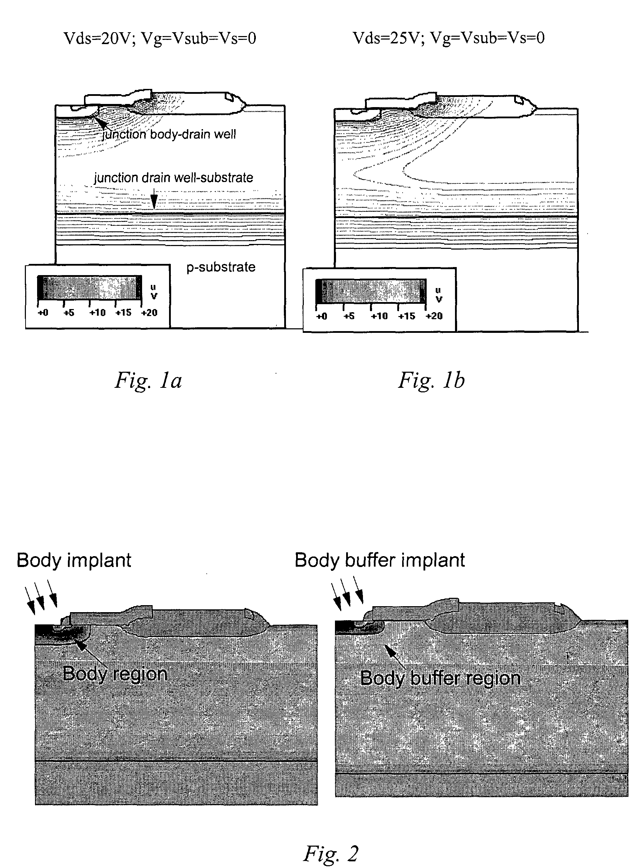

In order to understand better the principle that characterizes RESURF_LDMOS structures, reference should be made to figures 1a and 1b. The figures show two possible conditions of operation at different drain-source voltages (VDS). The shown LDMOS structure comprises a P-SUBSTRATE, a DRAIN_WELL region having an opposite type of conductivity and a body region. The figures also show the junctions between substrate and DRAIN_WELL and between the DRAIN_WELL and body regions.

Figure 1a depicts a typical shape of the depletion regions of the two above noted junctions when the source S, the body and the gate G are connected to a reference potential GND and a certain VDS voltage (VDS=20V) is applied to the drain D. Under these conditions of operation, the junctions are inversely biased because of the applied VDS voltage and the respective depletion regions extend into the DRAIN_WELL down to a certain depth.

By further incrementing the VDS voltage, as shown in Figure 1b (VDS=25V), the depletion regions of the junctions between the substrate and the DRAIN_WELL region and between the DRAIN_WELL region and the body merge, completely depleting the DRAIN_WELL thus producing the desired RESURF condition.

Under particular conditions of operation, such as in the case of a high side driver, in which relatively high drain gate and source voltages are applied while keeping the substrate to ground potential GND, the total depletion of the DRAIN_WELL may cause precocious punch-through (PT) phenomena between the body and the substrate. For this reason RESURF LDMOS are commonly employed as low side drivers, that is, operated with the source S and the substrate at ground potential.

There exists a need for a RESURF LDMOS structure capable of functioning a high side driver without the drawbacks and limitations of known devices.

### OBJECT AND SUMMARY OF THE INVENTION

It has now been found and is the object of the present invention a RESURF LDMOS structure that may be used at relatively high voltages without incurring into unduly precocious punch-through problems.

The structure of the invention overcomes the problems of the known structures by virtue of an effective anti punch-through (PT) region created between the body and the DRAIN_WELL, having the same type of conductivity of the DRAIN_WELL but being more heavily doped.

More precisely, the object of the invention is an integrated RESURF LDMOS structure realized in a first region of a first type of conductivity defined in a semiconductor substrate, and comprising a source region of the first type of conductivity formed in a body region of opposite type of conductivity.

The peculiarity of the invention is that the body region is contained in a portion close to the surface of the semiconductor of the first region more heavily doped that the body region.

In the most common use of an n-channel RESURF LDMOS structure, and in a process characterized by an n epitaxial layer with thickness of 3 µm, doped with phosphorous at a concentration of 6*10¹⁵ atoms cm⁻³ and where the body region is doped with boron at a concentration of 10¹⁸ atoms cm⁻³, the doping of said superficial portion of the region containing the body region may range between 5*10¹⁶ and 10¹⁷ atoms cm⁻³.

### BRIEF DESCRIPTION OF THE DRAWINGS

The different aspects and advantages of the invention will become even clearer through the following detailed description and by referring to the details shown in the attached drawings wherein:
**Figures 1a and 1b** illustrate the form of the depletion regions in a traditional RESURF LDMOS structure at two different drain-source voltages (VDS);
**Figure 2** shows a traditional LDMOS structure and the LDMOS structure of the invention for pointing out the difference between them;
**Figure 3a** shows typical potential lines in the structure of the invention during operation of the LDMOS transistor as a low side driver;
**Figure 3b** shows the distribution of the concentrations of charges in the structure of the invention during operation of the LDMOS transistor as a high side driver.

### DESCRIPTION OF AN EMBODIMENT OF THE INVENTION

The present invention provides a simple and effective solution to unduly precocious punch-through (PT) problems that normally limit the performance of known RESURF LDMOS structures when functioning as high side drivers, through introducing minor and uncritical changes in the known RESURF LDMOS structure. The invention consists in a RESURF LDMOS structure that includes a superficial portion of the DRAIN_WELL region, surrounding the body region, more heavily doped than the remainder portion of the DRAIN_WELL region, as shown in Figure 2.

It has now been found that by creating such a superficial BODY_BUFFER_REGION more heavily doped than the bulk of the DRAIN_WELL region, a marked enhancement of the RESURF LDMOS structure performance, especially when functioning as a high side driver at relatively high VDS voltages is achieved. Differently from what occurs in the bulk of the DRAIN_WELL, this superficial region is not completely depleted, thus averting the punch-through problems that restrict the conditions under which present LDMOS structures may safely be employed.

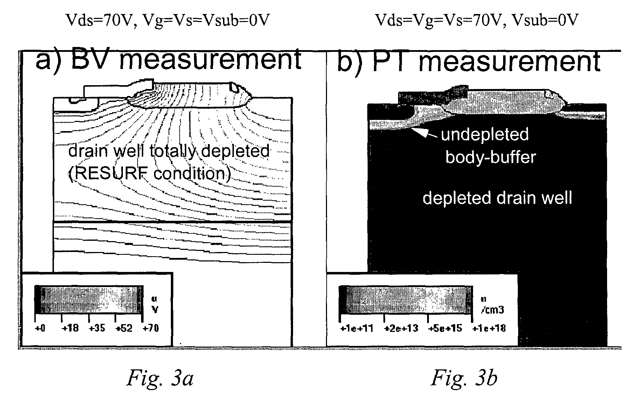

A better understanding of the principles on which the improved RESURF LDMOS structure of the invention rests may be denied by referring to Figures 3a and 3b.

As shown in figure 3b, even if relatively high voltages are applied to the drain and source (typical of a high-side functioning), the DRAIN_WELL will be completely depleted of its charges before this condition is reached by the superficial portion of it, herein named BODY_BUFFER_REGION, due to the heavier doping of the latter.

This effectively prevents the occurrence of punch-through (PT) phenomena at relatively low voltages, practically enhancing the performance of the structure of the invention under critical condition of use.

In practice, the presence of the BODY_BUFFER_REGION increases the level of voltage that must be reached before punch-through (PT) is caused, while on the other hand it may lower the breakdown voltage (BV).

The thickness and the doping level of the BODY_BUFFER_REGION should be established for the most appropriate compromise between the requisite of increasing the voltage level at which the punch-through (PT) may occur and the requisite of ensuring a sufficiently high breakdown voltage (BV). These parameters of the BODY_BUFFER_REGION may be accurately established at the design stage such to introduce negligible or tolerable reductions of the breakdown voltage (BV).

Solely by way of example, the table below give details about likely fabrication process variables. Preferred embodiments of the integrated n-channel RESURF_LDMOS of the invention in a p-type epitaxial layer and of a p-channel RESURF_LDMOS structure in an n-type epitaxial layer may be qualified by the characteristics reported in the following tables, respectively:

| region | Dopant | thickness [µm] | doping [atoms cm⁻³] |
|---|---|---|---|
| p-body (conductivity "P") | boron | 0.25÷0.75 | 5·10¹⁷ ÷5·10¹⁸ |
| body-buffer (conductivity "N") | phosphorous | 0.15÷0.45 | 5·10¹⁶ ÷5·10¹⁷ |
| drain well region (conductivity "N") | phosphorous | 1.5÷4.5 | 2.5·10¹⁵ ÷2.5·10¹⁶ |

| region | Dopant | thickness[µm] | doping [atoms cm⁻³] |
|---|---|---|---|
| n-body (conductivity "N") | phosphorous | 0.25÷0.75 | 5·10¹⁷÷5·10¹⁸ |
| body-buffer (conductivity "P") | boron | 0.15÷0.45 | 5·10¹⁶÷5·10¹⁷ |
| drain well region (conductivity "P") | boron | 1.5÷4.5 | 2.5·10¹⁵÷2.5·10¹⁶ |

Figure 3a shows a possible distribution of the potential lines in the structure of the invention functioning as a low side driver, that is, with the source S and the substrate at ground potential and positive voltage applied to the drain D.

The BODY_BUFFER_REGION should be realized such to become completely depleted because of the inverse biasing of the junction between the body and the DRAIN_WELL before breakdown conditions are reached.

Hence, when the drain voltage assumes values close to those of the expected breakdown voltage, the depletion regions of the inversely biased junctions extend into the BODY_BUFFER_REGION and into the DRAIN_WELL, as shown in figure 3a, thus determining the RESURF condition.

## Claims

1. A RESURF LDMOS integrated structure realized in a first region (DRAIN_WELL) of a first type of conductivity defined in a semiconductor substrate (P_SUBSTRATE) of opposite type of conductivity and comprising a source region of said first type of conductivity formed in a body region of said opposite type of conductivity, **characterized in that**
said body region is contained within a superficial portion (BODY_BUFFER_REGION) of said first region (DRAIN_WELL) more heavily doped than the rest of the region.

2. The integrated structure of claim 1, wherein said first region DRAIN_WELL has a depth comprised between 1.5 and 4.5 micrometers and doping comprised between 2.5*10¹⁵ and 2.5*10¹⁶ atoms cm⁻³, said superficial portion (BODY_BUFFER_REGION) is comprised between 0.15 and 0.45 micrometers deep and has a doping comprised between 5*10¹⁶ and 5*10¹⁷ atoms cm⁻³ and the depth of said body region is comprised between 0.25 and 0.75 micrometers and has a doping comprised between 5*10¹⁷ and 5*10¹⁸ atoms cm⁻³.

3. The integrated structure according to claims 1 or 2, wherein said first region (DRAIN_WELL) and said superficial portion thereof (BODY_BUFFER_REGION) are doped with phosphorous while said body region is doped with boron.

4. The integrated structure according to one of the claims 1 or 2, wherein said first region (DRAIN_WELL) and said superficial portion thereof (BODY_BUFFER_REGION) are doped with boron while said body region is doped with phosphorus.
